# EUROPÄISCHE PATENTSCHRIFT

(11) **EP 3 900 051 B1**
(45) Veröffentlichungstag und Bekanntmachung des Hinweises auf die Patenterteilung: **18.09.2024**
(21) Anmeldenummer: 19828669.2
(22) Anmeldetag: 17.12.2019
(51) Int. Cl.: H01L 31/0443

(54) **SCHALTUNGSANORDNUNG ZUR STROMERZEUGUNG MIT SERIENVERSCHALTETEN SOLARZELLEN MIT BYPASS-DIODEN**
CIRCUIT CONFIGURATION FOR POWER GENERATION COMPRISING SERIES-CONNECTED SOLAR CELLS HAVING BYPASS DIODES
DISPOSITIF DE COMMUTATION POUR LA GÉNÉRATION DE COURANT À L'AIDE DE CELLULES SOLAIRES COMMUTÉES EN SÉRIE PRÉSENTANT DES DIODES DE DÉRIVATION

(30) Priorität: 20.12.2018 DE 102018222591
(43) Veröffentlichungstag der Anmeldung: 27.10.2021
(73) Patentinhaber: Forschungszentrum Jülich GmbH, 52428 Jülich (DE)
(72) Erfinder: PIETERS, Bart Elger, 52428 Jülich (DE)
(74) Vertreter: Gille Hrabal Partnerschaftsgesellschaft mbB Patentanwälte
(86) Internationale Anmeldenummer: PCT/EP2019/085481
(87) Internationale Veröffentlichungsnummer: WO 2020/127142

(56) Entgegenhaltungen:
- JP-A- S59 129 478
- US-A1- 2010 078 057
- US-A1- 2012 291 835
- US-A1- 2013 104 954

## Beschreibung

Die Erfindung bezieht sich auf ein Solarmodul zur Stromerzeugung mit serienverschalteten Solarzellen mit Bypass - Dioden.

Eine Solarzelle, auch fotovoltaische Zelle genannt, ist ein elektronisches Bauelement, durch das Strahlungsenergie, insbesondere Licht, in elektrische Energie umwandelt werden kann. Eine Solarzelle umfasst ein fotovoltaisch aktives Material. Im fotovoltaisch aktiven Material können durch eine elektromagnetische Strahlung freie Ladungsträger erzeugt werden. An gegenüberliegenden Seiten des fotovoltaisch aktiven Materials grenzen zwei Elektroden an. Das fotovoltaisch aktive Material befindet sich dann also zwischen den zwei Elektroden.

Das fotovoltaisch aktive Material kann ein pn-Halbleiter sein. Beispielsweise durch ein elektrisches Feld, so zum Beispiel durch ein internes elektrisches Feld eines pn-Halbleiters, werden die erzeugten freien Ladungsträger aus dem fotovoltaisch aktiven Material herausgeführt. Über die angrenzenden Elektroden kann der so erzeugte elektrische Strom einem elektrischen Verbraucher zugeführt werden.

Ein pn - Halbleiter ist ein Halbleiter mit zwei Bereichen, die entgegengesetzt dotiert sind. Ein Bereich ist negativ dotiert und ein daran angrenzender Bereich ist positiv dotiert. Es resultiert ein pn-Übergang mit einer Sperrschicht, die beim Anlegen einer äußeren Spannung Stromfluss nur in einer Richtung zulässt, die also elektrischen Strom in einer Richtung passieren lässt und in der anderen Richtung den Stromfluss sperrt. Ein pn - Halbleiter, der sich zwischen zwei Elektroden befindet, ist also eine Diode, die durch Bestrahlen mit einer elektromagnetischen Welle Strom erzeugen kann, also als Solarzelle betrieben wird. Der dann erzeugte Strom fließt in Sperrrichtung der Diode.

Es ist bekannt, eine Mehrzahl von fotovoltaischen Zellen elektrisch miteinander seriell zu verbinden, um höhere elektrische Spannungen erzeugen zu können. Es fließt dann durch alle in Reihe bzw. in Serie verschalteten Solarzellen derselbe Strom.

Ein Solarmodul ist ein Bauteil, das eine Mehrzahl von fotovoltaischen Zellen umfasst, die elektrisch miteinander verbunden sind. Die fotovoltaischen Zellen eines Solarmoduls können sich auf einem gemeinsamen Substrat befinden. Ein Solarmodul kann aus Schutzgründen einen Rahmen und/oder ein oder mehrere Schutzschichten umfassen. Eine Schutzschicht schützt die fotovoltaischen Zellen vor schädlichen äußeren Einflüssen. Eine Schutzschicht kann aus Glas oder Kunststoff bestehen.

Wenn bei einem Solarmodul mit in Serie geschalteten Solarzellen eine einzelne Solarzelle weniger stark als die benachbarten Solarzellen oder gar nicht beleuchtet wird, liefern die anderen Solarzellen weiterhin Strom. An der abgeschatteten Solarzelle steigt dann die anliegende elektrische Spannung an. Überschreitet die Spannung der in Serie geschalteten funktionstüchtigen und bestrahlten Solarzellen die Sperrspannung der nicht bestrahlten Solarzelle, kann dies sogar zur Zerstörung derselben führen. Da die anderen Solarzellen weiterhin Strom liefern, kann sich an dieser Stelle eine Überhitzung bilden, die zu einem Brand führen kann. Dieser Effekt wird auch als "Hot Spot" bezeichnet. Das gleiche Problem tritt auf, wenn eine einzelne Solarzelle aus anderen Gründen nicht hinreichend funktionstüchtig ist.

Um solche Probleme zu vermeiden, können Dioden parallelgeschaltet zu den Solarzellen eingebaut sein. Solche Dioden werden Bypass - Dioden genannt und sind aus der Druckschrift US 2003/0000565 A1 bekannt. Bypass - Dioden überbrücken abgeschattete oder aus anderen Gründen nicht hinreichend funktionstüchtige Solarzellen elektrisch.

Aus der DE 299 23 380 U1 ist ein Solarmodul mit in Reihe geschalteten Solarzellen bekannt. Die Solarzellen sind auf einem gemeinsamen Substrat hintereinander angeordnet. Parallel und benachbart dazu gibt es auf demselben Substrat hintereinander angeordnete, in Reihe geschaltete Dioden. Sowohl die in Reihe geschalteten Dioden als auch die Solarzellen bestehen aus einer vorderseitigen und einer rückseitigen Elektrodenschicht und einer dazwischen angeordneten fotovoltaisch aktiven Schicht.

Aus den Druckschriften US 2013 / 0 104 954 A1, JP S59 129 478 A und US 2012 / 291 835 A1 sind Solarmodule bekannt, die mehrere Solarzellen und antiparallel zu den Solarzellen geschaltete Bypass-Dioden enthalten. Sowohl die Solarzellen als auch die Bypass-Dioden sind jeweils hintereinander angeordnet. Die US 2010 1078 057 A1 beschreibt dagegen eine flächige Anordnung von Solarzellen und Bypass-Dioden nebeneinander.

Es ist Aufgabe der Erfindung, ein zuverlässig funktionierendes Solarmodul technisch einfach herstellen zu können.

Diese Aufgabe wird durch ein Solarmodul mit den Merkmalen von Patentanspruch 1 gelöst. Vorteilhafte Ausgestaltungen ergeben sich aus den abhängigen Ansprüchen.

Das Solarmodul umfasst eine erste Mehrzahl von hintereinander angeordneten, elektrisch in Reihe geschalteten Solarzellen. Parallel zu jeder Solarzelle ist eine Bypass-Diode zur elektrischen Überbrückung elektrisch parallel geschaltet. Die Bypass - Dioden sind hintereinander angeordnet. Eine jede Solarzelle und eine jede Bypass-Diode umfassen eine fotovoltaisch aktive Schicht, eine untere elektrisch leitfähige Schicht und eine obere elektrisch leitfähige Schicht. Die jeweils untere elektrisch leitfähige Schicht und die darüber befindliche obere elektrisch leitfähige Schicht grenzen an eine dazwischen befindliche fotovoltaisch aktive Schicht an. Eine jede Bypass-Diode ist zwischen Solarzellen angeordnet. Es kann so eine zweite Mehrzahl von hintereinander angeordneten, elektrisch in Reihe geschalteten Solarzellen geben. Eine Solarzelle aus der ersten Mehrzahl ist dann mit einer Solarzelle aus der zweiten Mehrzahl elektrisch parallel geschaltet.

Hintereinander angeordnet meint eine räumliche Anordnung. Die Solarzellen bzw. die Bypass - Dioden bilden eine Schlange. In der Regel sind die hintereinander angeordneten Solarzellen bzw. die hintereinander angeordneten Bypass - Dioden entlang einer geraden Linie angeordnet. Möglich ist aber auch ein kurvenförmiger Verlauf. Grundsätzlich befinden sich die hintereinander angeordneten Solarzellen und/oder die hintereinander angeordneten Bypass - Dioden auf einem gemeinsamen Substrat.

"Eine jede Bypass-Diode ist zwischen Solarzellen angeordnet" meint, dass an zwei gegenüberliegenden Seiten einer jeden Bypass-Diode Bereiche angrenzen, die durch Bestrahlung mit einer elektromagnetischen Welle Strom erzeugen können und sollen. Die an gegenüberliegenden Seiten einer Bypass-Diode Bereiche angrenzenden Bereiche sind elektrisch parallel mit der dazwischen liegenden Bypass-Diode verbunden. Eine erste und eine zweite Mehrzahl von Solarzellen sind so möglich. Die Solarzellen der ersten Mehrzahl sind elektrisch seriell miteinander verbunden, um so höhere elektrische Spannungen bereitzustellen im Vergleich zur elektrischen Spannung, die eine einzelne Solarzelle bereitstellen kann. Aus dem gleichen Grund sind die Solarzellen der zweiten Mehrzahl ebenfalls elektrisch seriell miteinander verbunden Die erste und die zweite Mehrzahl von Solarzellen können räumlich parallel zueinander verlaufen. Eine jede Bypass - Diode dient zur elektrischen Überbrückung der daran seitlich angrenzenden Solarzellen. Räumlich hintereinander angeordnete Bypass - Dioden befinden sich dann zwischen der ersten Mehrzahl von Solarzellen und der zweiten Mehrzahl von Solarzellen.

"Fotovoltaisch aktive Schicht" meint, dass die Schicht aus einem fotovoltaisch aktiven Material besteht.

Dieser Aufbau ermöglicht es, ein Solarmodul technisch auf einfache Weise herzustellen. Eine dafür geeignete Strukturierung gelingt durch das Vorsehen von entsprechenden Gräben während der Herstellung. Gräben können gefüllt sein. So kann es Gräben geben, die mit einem elektrischen Leiter gefüllt ist, um elektrisch leitende Schichten miteinander zu verbinden. Es kann Gräben geben, die mit einem Material gefüllt sind, um die Herstellung zu erleichtern. Es kann Gräben geben, die mit einem Halbleitermaterial oder einem elektrisch isolierendem Material gefüllt sind, um elektrisch leitende Schichten elektrisch voneinander zu trennen.

Um besonders einfach zu fertigen, ist eine erste Bypass - Diode von einer daran angrenzenden zweiten Bypass - Diode durch zwei Gräben getrennt. Zwischen den beiden Gräben verläuft ein elektrischer Leiter, der obere und/oder untere elektrisch leitfähige Schichten von Solarzellen elektrisch leitend miteinander verbindet, die an die erste Bypass - Diode seitlich angrenzen.

Der elektrische Leiter, kann aus einer oberen elektrisch leitfähigen Schicht herausgearbeitet sein. Der elektrische Leiter, kann aus einer unteren elektrisch leitfähigen Schicht herausgearbeitet sein. Der elektrische Leiter kann sich zwischen zwei fotovoltaisch aktiven Schichten befinden.

Die beiden Gräben, die eine erste Bypass - Diode von einer daran angrenzenden zweiten Bypass - Diode durch zwei Gräben trennen, können mit Luft gefüllt sein oder mit einem anderen elektrisch isolierenden Material.

Die unteren elektrisch leitfähigen Schichten befinden sich bevorzugt auf einer elektrisch nicht leitfähigen Schicht, um eine Herstellung zu vereinfachen. Die elektrisch nicht leitfähige Schicht kann eine selbstragende Schicht, also ein Substrat, sein. Die elektrisch nicht leitfähige Schicht kann auf einem Substrat aufgebracht sein. Die elektrisch nicht leitfähige Schicht kann biegsam sein. Die elektrisch nicht leitfähige Schicht kann starr sein.

Die obere elektrisch leitfähige Schicht einer ersten Solarzelle ist vorzugsweise mit der unteren elektrisch leitfähigen Schicht einer angrenzenden zweiten Solarzelle durch einen elektrischen Leiter elektrisch leitend verbunden, um die beiden Solarzellen elektrisch in Reihe, also in Serie, geschaltet miteinander zu verbinden. Beide Solarzellen gehören dann entweder zu der ersten Mehrzahl der Solarzellen oder aber zu der zweiten Mehrzahl der Solarzellen.

Der elektrische Leiter, der die obere elektrisch leitfähige Schicht der ersten Solarzelle mit der unteren elektrisch leitfähigen Schicht einer angrenzenden zweiten Solarzelle elektrisch verbindet, trennt vorzugsweise die fotovoltaisch aktive Schicht der ersten Solarzelle von der fotovoltaisch aktiven Schicht der zweiten Solarzelle. Gemeint ist hier eine räumliche Trennung. Eine solche räumliche Trennung liegt vor, wenn sich die fotovoltaisch aktive Schicht der ersten Solarzelle vollständig oder zumindest überwiegend auf der einen Seite des elektrischen Leiters befindet und die fotovoltaisch aktive Schicht der zweiten Solarzelle vollständig oder zumindest überwiegend auf der anderen Seite des elektrischen Leiters befindet. Der elektrische Leiter befindet sich dann in einem Graben, der im genannten Sinn zwischen den beiden fotovoltaisch aktiven Schichten verläuft. Zusätzlich kann es noch einen weiteren Graben geben, der im genannten Sinn zwischen den beiden fotovoltaisch aktiven Schichten verläuft. Der weitere Graben kann beispielsweise mit einem elektrisch isolierenden Material gefüllt sein. Der Graben, der mit elektrisch leitfähigem Material gefüllt ist, um den genannten elektrischen Leiter zu bilden, kann räumlich benachbart zu dem Graben angeordnet sein, der mit einem elektrisch isolierenden Material gefüllt sein kann.

Die untere elektrisch leitfähige Schicht einer ersten Solarzelle ist von der unteren elektrisch leitfähigen Schicht einer angrenzenden zweiten Solarzelle vorzugsweise durch einen ersten Graben getrennt. Die obere elektrisch leitfähige Schicht der ersten Solarzelle ist von der oberen elektrisch leitfähigen Schicht der angrenzenden zweiten Solarzelle durch einen zweiten Graben getrennt. Der erste Graben soll zwei untere elektrisch leitfähige Schichten von zwei benachbarten Solarzellen elektrisch voneinander trennen. Der erste Graben kann beispielsweise mit einem Halbleitermaterial oder einem elektrischen Isolator gefüllt sein, um die elektrische Trennung zu erreichen. Der erste Graben muss nicht gefüllt sein, um die elektrische Trennung zu erreichen. Der erste Graben kann mit Material gefüllt sein, aus dem die daran angrenzende fotovoltaisch aktive Schicht besteht, um verbessert besonders einfach fertigen zu können.

Der zweite Graben soll zwei obere elektrisch leitfähige Schichten von zwei benachbarten Solarzellen elektrisch voneinander trennen. Der zweite Graben kann mit einem elektrischen Isolator oder einem Halbleiter gefüllt sein, um dies zu erreichen. Der Grund des zweiten Grabens kann durch eine untere elektrisch leitfähige Schicht gebildet sein. Der zweite Graben trennt dann die fotovoltaisch aktive Schicht einer ersten Solarzelle von der fotovoltaisch aktiven Schicht einer zweiten Solarzelle im vorgenannten Sinn. Der zweite Graben befindet sich dann insbesondere in der Nachbarschaft des genannten elektrischen Leiters, der zwei benachbarte Solarzellen seriell miteinander verbindet.

Eine untere elektrisch leitfähige Schicht einer Bypass-Diode kann von benachbarten unteren elektrisch leitfähigen Schichten von elektrisch parallel geschalteten Solarzellen durch Gräben getrennt sein, um die genannten unteren elektrisch leitfähigen Schichten voneinander elektrisch zu trennen. Die Gräben können beispielsweise mit einem Halbleitermaterial oder einem elektrischen Isolator gefüllt sein, um die elektrische Trennung zu erreichen. Die Gräben müssen nicht gefüllt sein, um die elektrische Trennung zu erreichen. Die Gräben können mit Material gefüllt sein, aus dem die daran angrenzende fotovoltaisch aktive Schicht besteht, um besonders einfach fertigen zu können. Die Gräben können durch sämtliche Schichten hindurchführen, also durch die oberen und unteren elektrisch leitfähigen Schichten und damit auch durch die fotovoltaisch aktiven Schichten.

Ein Graben, der die untere elektrisch leitfähige Schicht einer Bypass-Diode von einer benachbarten elektrisch leitfähigen Schicht einer elektrisch parallel geschalteten Solarzellen trennt, kann mit dem Material gefüllt sein, aus dem die daran angrenzende fotovoltaisch aktive Schicht besteht. Diese Ausführungsform erleichtert weiter verbessert die Herstellung.

Die obere elektrisch leitfähige Schicht einer Bypass-Diode kann von benachbarten oberen elektrisch leitfähigen Schichten von elektrisch parallel geschalteten Solarzellen durch Gräben getrennt sein, um die Herstellung weiter verbessert zu erleichtern.

Der Grund eines Grabens, der die obere elektrisch leitfähige Schicht einer Bypass-Diode von einer benachbarten oberen elektrisch leitfähigen Schicht einer elektrisch parallel geschalteten Solarzelle trennt, kann durch eine untere elektrisch leitfähige Schicht gebildet sein, um die Herstellung weiter verbessert zu erleichtern.

Die obere elektrisch leitfähige Schicht einer Bypass-Diode kann mit einer benachbarten unteren elektrisch leitfähigen Schicht einer ersten elektrisch parallel geschalteten Solarzelle durch einen elektrischen Leiter elektrisch leitend verbunden sein. Die untere elektrisch leitfähige Schicht der Bypass-Diode kann mit einer benachbarten oberen elektrisch leitfähigen Schicht einer elektrisch parallel geschalteten zweiten Solarzelle durch einen elektrischen Leiter elektrisch leitend verbunden sein. Herstellungsvorteile können so weiter verbessert erzielt werden.

Ein elektrischer Leiter, der eine elektrisch leitende Schicht einer Bypass-Diode mit einer benachbarten elektrisch leitfähigen Schicht einer elektrisch parallel geschalteten Solarzelle elektrisch verbindet, kann eine fotovoltaisch aktive Schicht der Bypass-Diode von der fotovoltaisch aktiven Schicht der Solarzelle trennen, um Herstellungsvorteile zu erzielen..

Eine erste Bypass - Diode kann von einer daran angrenzenden zweiten Bypass - Diode durch wenigstens einen Graben getrennt sein, was technisch einfach gefertigt werden kann.

Eine erste Bypass - Diode kann von einer daran angrenzenden zweiten Bypass - Diode durch zwei Gräben getrennt sein. Zwischen den beiden Gräben kann ein elektrischer Leiter verlaufen, der obere elektrisch leitfähige Schichten von Solarzellen elektrisch leitend miteinander verbindet, die an die erste Bypass - Diode seitlich angrenzen und der untere elektrisch leitfähige Schichten von Solarzellen elektrisch leitend miteinander verbindet, die an die zweite Bypass - Diode seitlich angrenzen. Eine technisch einfache Fertigung wird dadurch weiter verbessert möglich.

Ein oder mehren Gräben, die eine erste Bypass - Diode von einer daran angrenzenden zweiten Bypass - Diode trennen, können durch sämtliche Schichten der beiden Bypass - Dioden hindurchführen. Ein solcher Graben reicht dann also von der Oberseite der oberen elektrisch leitfähigen Schicht bis zu der Unterseite der unteren elektrisch leitfähigen Schicht der Bypass - Diode. Dies kann ebenfalls technisch einfach gefertigt werden.

Fotovoltaisch aktive Schichten können aus einem pn-Halbleiter bestehen.

Die Solarzellen und die Bypass - Dioden sind vorzugsweise in einer Ebene angeordnet. Insbesondere sind die unteren elektrisch leitfähige Schichten der Solarzellen und der Bypass - Dioden gleich dick und liegen in der gleichen Ebene. Insbesondere sind die oberen elektrisch leitfähige Schichten der Solarzellen und der Bypass - Dioden gleich dick und liegen in der gleichen Ebene. Insbesondere sind die fotovoltaisch aktiven Schichten der Solarzellen und der Bypass - Dioden gleich dick und liegen in der gleichen Ebene.

Vorzugsweise sind die Bypass - Dioden abgeschattet, um elektrische Leistungsverluste zu minimieren. Sind Bypass - Dioden abgeschattet, so kann eine elektromagnetische Strahlung, insbesondere kein Licht, auf die Bypass - Dioden so auftreffen, dass ein elektrischer Strom durch die Bypass - Dioden erzeugt werden kann. Das Abschatten kann auf technisch einfache Weise durch einen entsprechend undurchlässigen Lack erreicht werden. Das Abschatten kann auf technisch einfache Weise durch entsprechend undurchlässige ein oder mehrere Schichten erreicht werden.

Eine Oberseite einer jeden Bypass-Diode ist vorzugsweise kleiner als eine Oberseite einer jeden Solarzelle, um hohe elektrische Leistungen zu ermöglichen. Insbesondere ist die Oberseite einer jeden Solarzelle wenigstens doppelt so groß wie die Oberseite einer jeden Bypass - Diode. Mit Oberseite ist eine Oberfläche gemeint, die in Aufsicht auf das Solarmodul gesehen wird.

Mit dem erfindungsgemäßen Solarmodul ist es möglich, ein industriell einfach herzustellendes und effizientes Solarmodul mit Bypass - Dioden bereitzustellen. Dabei liegt der Erfindung die Erkenntnis zu Grunde, dass bei den aus dem Stand der Technik bekannten Solarmodulen mit Bypass - Dioden für die Integration der Bypass - Dioden in das Solarmodul häufig eine technisch aufwendige Strukturierung erforderlich ist.

Die Erfindung ermöglicht geradlinige Strukturierungen und Verschaltungen, was eine Herstellung erleichtert. Auf verwinkelte Strukturierungsgräben kann vorteilhaft verzichtet werden.

Erfindungsgemäß wird ein Solarmodul mit serienverschalteten Solarzellen bereitgestellt, bei dem jede Solarzelle des Solarmoduls mit wenigstens einer Bypass-Diode parallel verschaltet ist, die für den Fall einer vollständigen oder teilweisen Abschattung oder einer Funktionsminderung dieser Solarzelle den erzeugten elektrischen Strom an dieser Solarzelle vorbeileiten kann.

Das Solarmodul kann sowohl in Superstrat- als auch in Substratstruktur aufgebaut sein.

Die Superstratstrukturen umfassen ein Substrat, eine darauf abgeschiedene erste Elektrodenschicht (vorderseitige Elektrodenschicht), auf die die fotovoltaisch aktive Schicht aufgebracht ist und der anschließenden zweiten Elektrodenschicht (rückseitige Elektrodenschicht). Die elektrisch leitfähigen Schichten bilden die Elektrodenschichten. Im Fall der Superstratstruktur sind das Substrat und die vorderseitige Elektrodenschicht transparent ausgestaltet, so dass die Strahlung durch diese Schichtfolge eindringen kann.

Bei der Substratstruktur erfolgt die Reihenfolge der Beschichtung umgekehrt: Auf das Substrat wird zunächst die rückseitige Elektrodenschicht, die in diesem Fall transparent ausgeführt ist, dann die fotovoltaisch aktive Schicht und abschließend die vorderseitige Elektrodenschicht aufgebracht. Die Bestrahlung erfolgt dann zuerst durch die rückseitige, transparente Elektrodenschicht auf die fotovoltaisch aktive Schicht.

Als Substrate sind alle in der Solarzellentechnologie, insbesondere CIGS (Kupfer-Indium-Gallium- Diselenid)-Dünnschichtsolarzellentechnologie sowie in der CdTe (Cadmium Tellurid)-Dünnschichtsolarzellentechnologie, als solches gebräuchlichen Substrate oder Superstrate frei wählbar, wie z. B. Glas/Molybdän als Substrat für CIGS oder z. B. Glas/TCO als Superstrat für CdTe.

Die genannten Substrate und Superstrate sind in Dünnschicht-Silizium-Solarzellen üblich. Derzeit sind die relevanten Dünnschichttechnologien CdTe und CIGS, wobei CdTe typischerweise auf Glas/TCO-Superstrat und CIGS auf Glas/Molydenum-Substrat aufgebracht wird.

Ein Substrat kann Funktionsschichten zur verbesserten Lichtstreuung oder zum verbesserten Aufwachsen der Kontaktschicht auf dem Träger umfassen.

Für die erste elektrische leitfähige Schicht kann Material, wie z. B. Mo oder Ag (für Substratstruktur) oder ZnO, SnO₂ oder ITO (für Superstratstruktur) gewählt werden. Auf einer derartigen Schichtstruktur aus Substrat und ersten elektrisch leitfähigen Schichten können im Weiteren die fotovoltaisch aktiven Schichten auf den streifenförmigen ersten elektrisch leitfähigen Schichten, bzw. oberhalb von Gräben, aufgebracht sein.

Das erfindungsgemäße Solarmodul umfasst eine Anzahl hintereinander angeordneter, elektrisch in Serie geschalteter Solarzellen, mit einer Schichtstruktur umfassend eine vorderseitige und eine rückseitige Elektrodenschicht und einer dazwischen angeordneten fotovoltaisch aktiven Schicht, sowie eine Anzahl parallel zur jeweiligen Solarzelle geschalteter Bypass - Dioden, welche eine Schichtstruktur wie die Solarzellen aufweisen, wobei benachbarte Bypass - Dioden untereinander nicht miteinander elektrisch leitend kontaktiert sind und jede Bypass - Diode jeweils rechts und links mit einer Solarzelle parallel verschaltet ist.

Im Weiteren wird die Erfindung an Hand von Ausführungsbeispielen und der beigefügten Figuren näher erläutert, ohne dass es hierdurch zu einer Einschränkung der Erfindung kommen soll.

Im Folgenden sind Ausführungsbeispiele der Erfindung anhand der Figuren näher erläutert. Es zeigen in schematischer Weise:
- Fig. 1:: durch Solarzellen 10, 11, 12 und 13 eines Solarmoduls
- Fig. 2a:: Aufsicht auf ein Solarmodul
- Fig. 2b:: elektrisches Ersatzschaltbild des Solarmoduls aus Figur 2a
- Fig. 3:: Schnittdarstellung durch Solarmodul aus Figur 2a
- Fig. 4:: Schnittdarstellung durch Solarmodul aus Figur 2a
- Fig. 5:: Aufsicht auf ein Solarmodul gemäß einem zweiten Ausführungsbeispiel (nicht Teil der Erfindung)

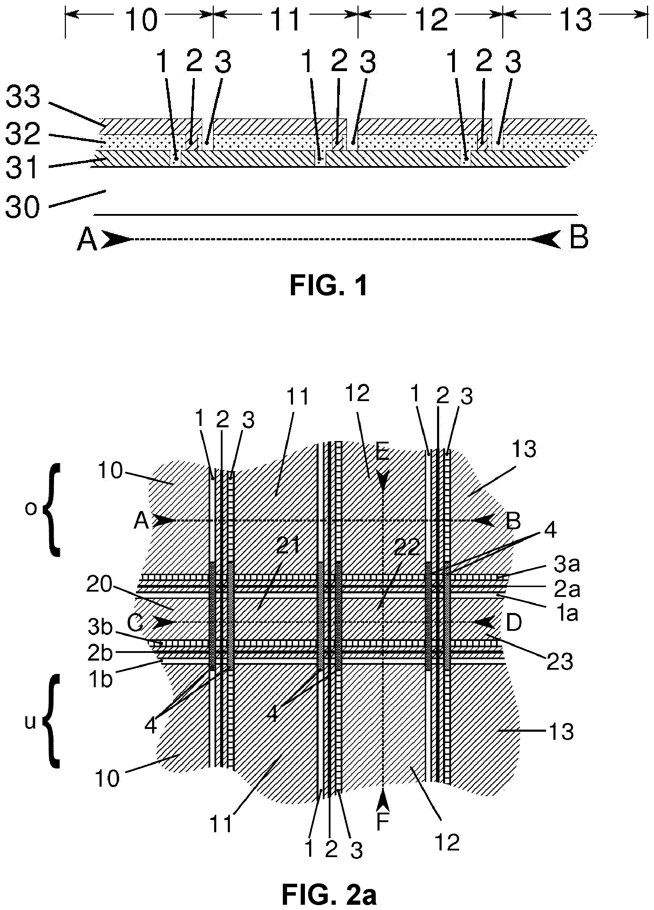

Die Figur 1 zeigt einen Schnitt durch Solarzellen 10, 11, 12 und 13 eines Solarmoduls.

Zunächst sind elektrisch leitfähige Schichten 31 so auf einem elektrisch nicht leitfähigen Substrat 30 hergestellt worden, dass die Schichten 31 hintereinander wie in der Figur 1 gezeigt auf dem Substrat 30 aufgebracht und durch Gräben 1 elektrisch voneinander getrennt sind. Die Gräben 1 können mit einem fotovoltaisch aktiven Material gefüllt sein, was aber für ein Funktionieren des Solarmoduls nicht erforderlich ist. Die Schichten 31 können durch ein Druckverfahren auf dem Substrat 30 aufgebracht worden sein. Es kann aber auch zunächst eine durchgehende elektrisch leitfähige Schicht auf dem Substrat 30 aufgebracht worden sein, die nach ihrem Aufbringen durch Gräben 1 unterteilt wurde.

In einem nächsten Schritt ist ein fotovoltaisch aktives Material so aufgebracht und bearbeitet ggfs. worden, dass hintereinander angeordnete Schichten 32 entstanden sind, die durch mit elektrisch leitfähigem Material gefüllte Gräben 2 voneinander getrennt sind. Das fotovoltaisch aktive Material kann durch das Auftragen herstellungsbedingt in die Gräben 1 gelangt sein. Dies ist aber nicht notwendig.

Das fotovoltaisch aktive Material kann zunächst als eine durchgehende Schicht aufgetragen worden sein, in die nach dem Auftragen mit elektrisch leitfähigem Material zu verfüllende Gräben durch Entfernen von Material eingebracht wurde. Alternativ können die Schichten 32 in nur einem Arbeitsschritt durch ein Druckverfahren aufgebracht worden sein, ohne dass im Anschluss daran Material entfernt werden musste, um mit elektrisch leitfähigem Material zu verfüllende Gräben und gegebenenfalls auch weitere Gräben 3 zu schaffen.

In einem nächsten Schritt wurde elektrisch leitfähiges Material auf die Schichten 32 schichtförmig aufgetragen und ggfs. so bearbeitet, dass diese durch die Gräben 2 hindurch die elektrisch leitfähigen Schichten 31 elektrisch kontaktieren und als Schichten 33 vorliegen, die durch Gräben 3 elektrisch voneinander getrennt sind. Die Gräben 3 können durch Entfernen von Material hergestellt worden sein. Die Gräben 3 können an die untersten elektrisch leitfähigen Schichten 31 angrenzen. Die Gräben 3 können aber auch durch Drucken entstanden sein.

Auf diese Weise werden Solarzellen 10, 11, 12, 13 eines Solarmoduls hergestellt, die hintereinander angeordnet sind und die elektrisch in Reihe geschaltet sind. Eine jede Solarzelle umfasst eine untere schichtförmige Elektrode 31 und eine obere schichtförmige Elektrode 32. Die beiden Elektroden 31 und 32 sind durch eine fotovoltaisch aktive Halbleiterschicht 32 voneinander getrennt. Die Solarzellen 10, 11, 12 und 13 sind hintereinander angeordnet und durch die mit elektrisch leitfähigem Material gefüllten Gräben 2 elektrisch in Serie geschaltet.

In der Figur 2a wird eine Aufsicht auf ein Solarmodul mit solchen Solarzellen 10, 11, 12, 13 gezeigt. Der Schnitt aus der Figur 1 verläuft entlang der in der Figur 2a gezeigten Schnittlinie AB.

Um nun zu einem erfindungsgemäßen Solarmodul zu gelangen, werden wie in der Figur 2a gezeigt parallel geschaltete Bypass-Dioden 20, 21, 22, 23 für die Solarzellen 10, 11, 12, 13 gefertigt. Um die parallel zu den Solarzellen 10, 11, 12, 13 geschaltete Bypass-Dioden 20, 21, 22, 23 herzustellen, werden die Gräben 1, 2, 3 nicht nur in einer Richtung quer zu den Solarzellen 10, 11, 12, 13 gefertigt, sondern auch paarweise parallel zu den Solarzellen 10, 11, 12, 13. Auf die quer gefertigten Gräben verweisen in der Figur 2a die Bezugszeichen 1a, 2a, 3a sowie 1b, 2b, 3b. Diese quer gefertigten Gräben 1a, 2a, 3a bzw. 1b, 2b, 3b können in gleicher Weise gefertigt worden sein wie anhand der Figur 1 beschrieben. Die Gräben 1a, 1b können wie die Gräben 1 mit einem fotovoltaisch aktiven Material gefüllt sein, was aber für ein Funktionieren des Solarmoduls nicht erforderlich ist. Die Gräben 2a und 2b sind wie die Gräben 2 mit elektrisch leitfähigem Material gefüllt. Die Gräben 3a, 3b können an die untersten elektrisch leitfähigen Schichten 31 angrenzen.

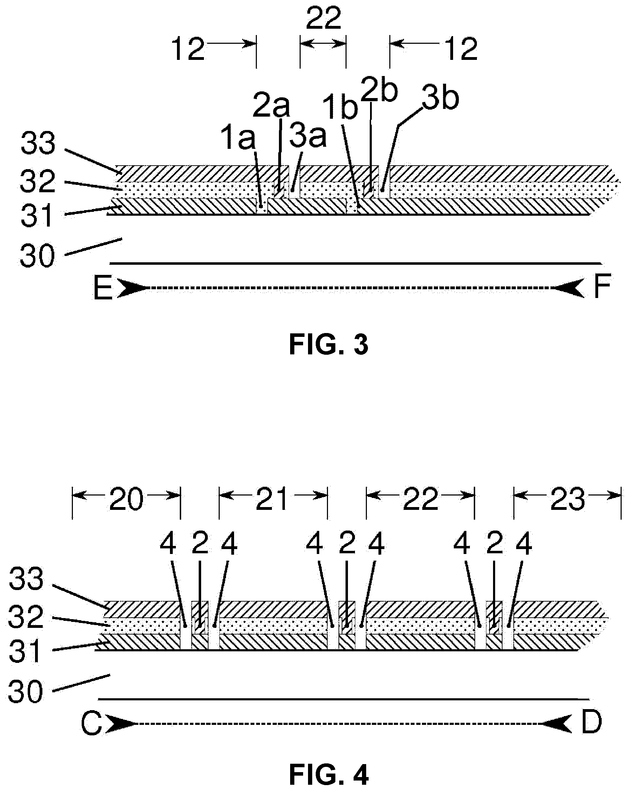

Die Figur 3 verdeutlicht dies in einer Schnittdarstellung entlang der Schnittlinie EF aus Figur 2a.

Außerdem werden Gräben 4 hergestellt, wie diese in der Figur 4 anhand einer Schnittdarstellung entlang der Schnittlinie CD aus Figur 2a gezeigt werden. Die Gräben 4 reichen bis zum Substrat 30. Die Gräben 4 werden insbesondere durch eine nachträgliche Entfernung von Material gefertigt. Möglich ist aber auch, diese Gräben 4 unmittelbar durch Drucken zu erzeugen.

Durch diese zusätzlichen Gräben sind Solarzellen nicht nur in Serie geschaltet, sondern zusätzlich auch parallel geschaltet. Dies wird in der Figur 2a durch die geschweiften Klammern verdeutlicht, die mit "o" für die oberen Solarzellen und mit "u" für die unteren Solarzellen gekennzeichnet sind. Die mit "o" gekennzeichneten Solarzellen bilden eine erste Mehrzahl von hintereinander angeordneten Solarzellen, die elektrisch seriell miteinander verbunden sind. Die mit "u" gekennzeichneten Solarzellen bilden eine zweite Mehrzahl von hintereinander angeordneten Solarzellen, die elektrisch seriell miteinander verbunden sind. Zwischen zwei elektrisch parallel geschalteten Solarzellen befindet sich eine Bypass-Diode.

Die Figur 2a zeigt, dass eine jede Oberseite bzw. Oberfläche einer jeden Solarzelle 10, 11, 12, 13 größer als eine jede Oberseite bzw. Oberfläche einer jeden Bypass - Diode. Die Figur 2a verdeutlicht, dass technisch einfach zu fertigende geradlinige Strukturen genügen, um das Solarmodul herzustellen.

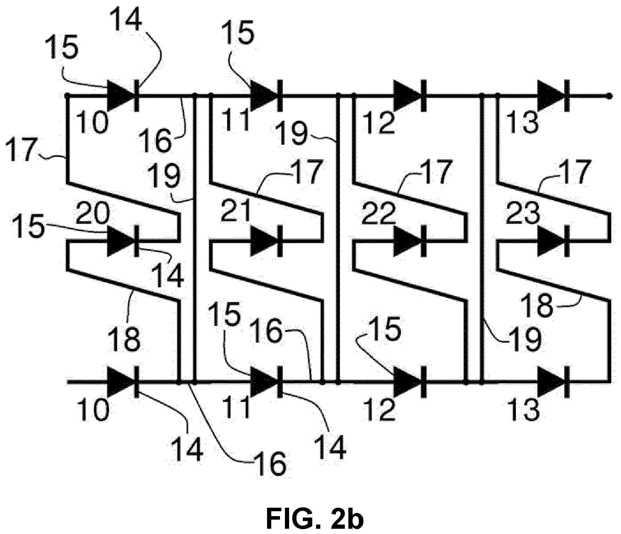

Die Figur 2b zeigt ein elektrisches Ersatzschaltbild des Solarmoduls aus Figur 2a. Dioden 10, 11, 12, 13 sind elektrisch seriell miteinander verbunden. Dafür ist die Anodenseite 14 einer links gezeigten, oben Solarzelle 10 mit der Kathodenseite 15 einer räumlich nachfolgenden, daran angrenzenden Solarzelle 11 über einen elektrischen Leiter 16 verbunden. Die nachfolgende Solarzelle 11 ist entsprechend mit der nachfolgenden Solarzelle 12 elektrisch leitend verbunden. Die Solarzelle 12 ist entsprechend mit der nachfolgenden Solarzelle 13 elektrisch leitend verbunden. Dies gilt sowohl für die obere als auch die untere Mehrzahl von Solarzellen 10,11, 12,13. Die Solarzellen 10, 11, 12, 13 sind wie die Dioden 20, 21, 22, 23 aufgebaut.

Wird eine Diode als Solarzelle betrieben, die also dann mit einer elektromagnetischen Strahlung, insbesondere Licht, bestrahlt wird, so wird ein elektrischer Strom erzeugt, den die Diode bei fehlender Beleuchtung nicht durchlässt. Erzeugen die Solarzellen 10, 11 und 13 einen Strom und die parallel geschaltete Solarzellen 12 keinen Strom, so fließt der erzeugte Strom von rechts nach links. Der von der oberen parallel geschalteten Solarzelle 13 über den Leiter 16 kommende Strom passiert die Bypass - Diode 22 über die elektrischen Leiter 17 und 18, wodurch die beiden dazu parallel geschalteten Solarzellen 12 überbrückt werden. Der von der unteren Solarzelle 13 über den elektrischen Leiter 16 kommende Strom überbrückt mittels der elektrischen Leiter 19, 17, 18 und der Bypass-Diode 22 die beiden Solarzellen 22.

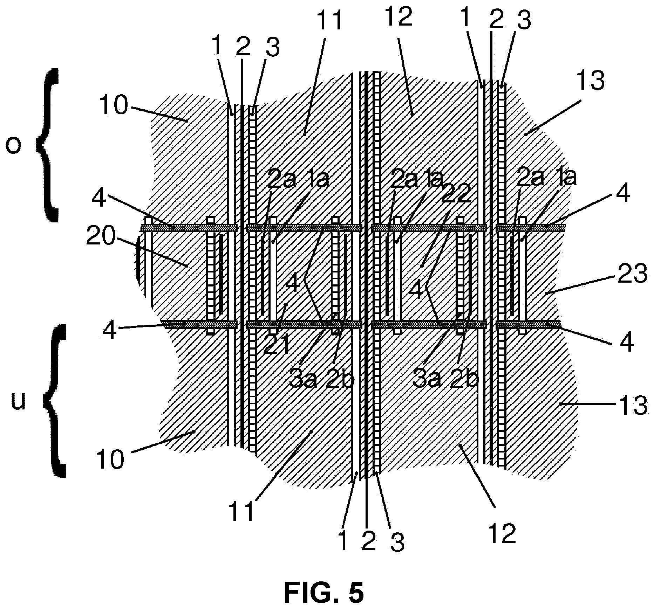

Das in der Figur 5 gezeigte Ausführungsbeispiel (nicht Teil der Erfindung) zeigt, dass die in der Figur 2b gezeigte Verschaltung auch durch anders angeordnete geradlinig verlaufende Gräben erreicht werden und eine Fertigung von verwinkelten Gräben entfallen kann. Die Solarzellen 10, 11, 12, 13 sind wie im Fall der Figur 2a durch geradlinig verlaufende Gräben 1, 2, 3 miteinander verschaltet. Die Gräben 1 können wiederum wie beschrieben mit dem Halbleitermaterial gefüllt sein, aus denen die fotovoltaisch aktiven Schichten 32 bestehen. Die Gräben 2 sind wie zuvor beschrieben mit elektrisch leitendem Material gefüllt. Die Gräben 3 können wie zuvor beschrieben mit einem elektrisch nicht leitenden Material gefüllt sein.

Durch quer zu den Gräben 1, 2, 3 verlaufende Gräben 4 sind die oberen und unteren Solarzellen 10, 11, 12, 13 von den Bypass - Dioden 20, 21, 22, 23 geeignet getrennt. Parallel dazu verlaufende Gräben 1a, 2a, 3a, 2b, die wie bereits beschrieben mit anderem Material gefüllt sein können oder gefüllt sind, vervollständigen das Solarmodul, um zu einem Ersatzschaltbild gemäß Figur 2b zu gelangen.

Wiederum genügen geradlinig zu Strukturierungen, um ein erfindungsgemäßes Solarmodul zu schaffen. Eine Schaffung eines Grabens, der verwinkelt verläuft, ist wiederum nicht erforderlich.

In den Figuren 2a und 5 werden Ausführungsbeispiele mit gerade verlaufenden Strukturen gezeigt. Derartige Verläufe sind aus Fertigungsgründen meistens zu bevorzugen. Es sind aber auch bogenförmige Verläufe möglich, was von Interesse sein kann, wenn Einbausituationen bogenförmige Verläufe erfordern. Auch die parallelen Verläufe von Strukturen, wie diese in den Figuren 2a und 5 gezeigt werden, sind nicht notwendig. Stattdessen können beispielsweise rechteckartig verlaufende Geometrien realisiert sein, um die vorliegende Erfindung zu verwirklichen.

### Bezugszeichen:

- 1:: Graben 1 gemäß einem Strukturierungsschritt P1
- 2:: Graben 2 gemäß einem Strukturierungsschritt P2
- 3:: Graben 3 gemäß einem Strukturierungsschritt P3
- 4:: Graben 4 gemäß einem Strukturierungsschritt P4
- 1a:: Graben 1a gemäß einem Strukturierungsschritt P1a
- 2a:: Graben 2a gemäß einem Strukturierungsschritt P2a
- 3a:: Graben 3a gemäß einem Strukturierungsschritt P3a
- 1b:: Graben 1b gemäß einem Strukturierungsschritt P1b
- 2b:: Graben 2b gemäß einem Strukturierungsschritt P2b
- 3b:: Graben 3b gemäß einem Strukturierungsschritt P3b
- 10:: Solarzelle
- 11:: Solarzelle
- 12:: Solarzelle
- 13:: Solarzelle
- 14:: Anodenseite
- 15:: Kathodenseite
- 16:: elektrischer Leiter
- 17:: elektrischer Leiter
- 18:: elektrischer Leiter
- 19 :: elektrischer Leiter
- 20:: Bypass Diode
- 21:: Bypass Diode
- 22:: Bypass Diode
- 23:: Bypass Diode
- 30:: Substratschicht
- 31:: Elektrodenschicht
- 32:: Halbleiterschicht
- 33:: Elektrodenschicht

## Patentansprüche

1. Solarmodul mit einer Mehrzahl von hintereinander angeordneten, elektrisch in Reihe geschalteten Solarzellen (10, 11, 12, 13), wobei zu jeder Solarzelle (10, 11, 12, 13) eine Bypass-Diode (20, 21, 22, 23) zur elektrischen Überbrückung elektrisch parallel geschaltet ist, wobei die Bypass - Dioden (20, 21, 22, 23) hintereinander angeordnet sind, wobei eine jede Solarzelle (10, 11, 12, 13) und eine jede Bypass-Diode (20, 21, 22, 23) eine fotovoltaisch aktive Schicht (32) umfassen sowie eine untere elektrisch leitfähige Schicht (31) und eine obere elektrisch leitfähige Schicht (33), die an die fotovoltaisch aktive Schicht (32) grenzen, wobei an zwei gegenüberliegenden Seiten einer jeden Bypass-Diode (20, 21, 22, 23) elektrisch parallel geschaltete Solarzellen (10, 11, 12, 13) angrenzen und die an gegenüberliegenden Seiten einer Bypass-Diode (20, 21, 22, 23) angrenzenden Solarzellen (10, 11, 12, 13) elektrisch parallel mit der dazwischen liegenden Bypass-Diode (20, 21, 22, 23) verbunden sind, **dadurch gekennzeichnet, dass** eine erste Bypass - Diode (20) von einer daran angrenzenden zweiten Bypass - Diode (21) durch zwei Gräben (4) elektrisch getrennt ist und zwischen den beiden Gräben (4) ein elektrischer Leiter (2, 31) verläuft, der obere elektrisch leitfähige Schichten (33) derjenigen Solarzellen (10) elektrisch leitend miteinander verbindet, die an die erste Bypass - Diode (20) seitlich angrenzen, und/oder der untere elektrisch leitfähige Schichten (31) derjenigen Solarzellen (10) elektrisch leitend miteinander verbindet, die an die zweite Bypass - Diode (20) seitlich angrenzen.

2. Solarmodul nach einem der vorhergehenden Ansprüche, **dadurch gekennzeichnet, dass** die obere elektrisch leitfähige Schicht (33) einer ersten Solarzelle (10) mit der unteren elektrisch leitfähigen Schicht (31) einer angrenzenden zweiten Solarzelle (11) durch einen elektrischen Leiter (2) elektrisch leitend verbunden ist.

3. Solarmodul nach dem vorhergehenden Anspruch, **dadurch gekennzeichnet, dass** der elektrische Leiter (2) die fotovoltaisch aktive Schicht (32) der ersten Solarzelle (10) von der fotovoltaisch aktiven Schicht (32) der zweiten Solarzelle (10) räumlich trennt.

4. Solarmodul nach einem der vorhergehenden Ansprüche, **dadurch gekennzeichnet, dass** die untere elektrisch leitfähige Schicht (31) einer ersten Solarzelle (10) von der unteren elektrisch leitfähigen Schicht (31) einer angrenzenden zweiten Solarzelle (11) durch einen ersten Graben (1) elektrisch getrennt ist und die obere elektrisch leitfähige Schicht (33) der ersten Solarzelle (10) von der oberen elektrisch leitfähigen Schicht (33) der angrenzenden zweiten Solarzelle (11) durch einen zweiten Graben (3) elektrisch getrennt ist.

5. Solarmodul nach dem vorhergehenden Anspruch, **dadurch gekennzeichnet, dass** der erste Graben (1) mit dem Material gefüllt ist, aus dem die daran angrenzende fotovoltaisch aktive Schicht (32) besteht.

6. Solarmodul nach einem der beiden vorhergehenden Ansprüche, **dadurch gekennzeichnet, dass** der Grund des zweiten Grabens (3) durch eine untere elektrisch leitfähige Schicht (31) gebildet ist.

7. Solarmodul nach einem der vorhergehenden Ansprüche, **dadurch gekennzeichnet, dass** eine untere elektrisch leitfähige Schicht (31) einer Bypass-Diode (20, 21, 22, 23) von benachbarten unteren elektrisch leitfähigen Schichten (31) von elektrisch parallel geschalteten Solarzellen (10, 11, 12, 13) durch Gräben (1a, 1b) elektrisch getrennt ist.

8. Solarmodul nach dem vorhergehenden Anspruch, **dadurch gekennzeichnet, dass** ein Graben (1a, 1b), der die untere elektrisch leitfähige Schicht (31) der Bypass-Diode (20, 21, 22, 23) von einer benachbarten elektrisch leitfähigen Schicht (31) einer elektrisch parallel geschalteten Solarzelle (10, 11, 12, 13) elektrisch trennt, mit dem Material gefüllt ist, aus dem die daran angrenzende fotovoltaisch aktive Schicht (32) besteht.

9. Solarmodul nach einem der vorhergehenden Ansprüche, **dadurch gekennzeichnet, dass** die obere elektrisch leitfähige Schicht (33) einer Bypass-Diode (20, 21, 22, 23) von benachbarten oberen elektrisch leitfähigen Schichten (33) von elektrisch parallel geschalteten Solarzellen (10, 11, 12, 13) durch Gräben (3a, 3b) elektrisch getrennt ist.

10. Solarmodul nach dem vorhergehenden Anspruch, **dadurch gekennzeichnet, dass** der Grund eines Grabens (3a, 3b), der die obere elektrisch leitfähige Schicht (33) einer Bypass-Diode (20, 21, 22, 23) von einer benachbarten oberen elektrisch leitfähigen Schicht (33) von einer elektrisch parallel geschalteten Solarzelle (10, 11, 12, 13) elektrisch trennt, durch eine untere elektrisch leitfähige Schicht (31) gebildet ist.

11. Solarmodul nach einem der vorhergehenden Ansprüche, **dadurch gekennzeichnet, dass** die obere elektrisch leitfähige Schicht (33) einer Bypass-Diode (20, 21, 22, 23) mit einer benachbarten unteren elektrisch leitfähigen Schicht (31) einer ersten elektrisch parallel geschalteten Solarzelle (10, 11, 12, 13) durch einen elektrischen Leiter (2a) elektrisch leitend verbunden ist und die untere elektrisch leitfähige Schicht (33) der Bypass-Diode (20, 21, 22, 23) mit einer benachbarten oberen elektrisch leitfähigen Schicht (33) einer elektrisch parallel geschalteten zweiten Solarzelle (10, 11, 12, 13) durch einen elektrischen Leiter (2b) elektrisch leitend verbunden ist.

12. Solarmodul nach dem vorhergehenden Anspruch, **dadurch gekennzeichnet, dass** ein elektrischer Leiter (2a, 2b), der eine elektrisch leitende Schicht (31, 33) der Bypass-Diode (20, 21, 22, 23) mit einer benachbarten elektrisch leitfähigen Schicht (33) einer elektrisch parallel geschalteten Solarzelle (10, 11, 12, 13) elektrisch verbindet, die fotovoltaisch aktive Schicht (32) der Bypass-Diode (20, 21, 22, 23) von der fotovoltaisch aktiven Schicht (32) der Solarzelle (10) räumlich trennt.

13. Solarmodul nach einem der vorhergehenden Ansprüche, **dadurch gekennzeichnet, dass** die ein oder mehreren Gräben (4), die eine erste Bypass - Diode (20) von einer daran angrenzenden zweiten Bypass - Diode (21) trennen, durch sämtliche Schichten (31, 32, 33) der beiden Bypass - Dioden (20, 21) hindurchführen.

14. Solarmodul nach einem der vorhergehenden Ansprüche, **dadurch gekennzeichnet, dass** die Solarzellen (10, 11, 12, 13) und die Bypass - Dioden (20, 21, 22, 23) in einer Ebene angeordnet sind.

15. Solarmodul nach einem der vorhergehenden Ansprüche, **dadurch gekennzeichnet, dass** die Bypass - Dioden (20, 21, 22, 23) abgeschattet sind.

## Claims

1. Solar module having a plurality of solar cells (10, 11, 12, 13) arranged one behind the other and electrically connected in series, wherein a bypass diode (20, 21, 22, 23) for electrical bypassing is electrically connected in parallel with each solar cell (10, 11, 12, 13), wherein the bypass diodes (20, 21, 22, 23) are arranged one behind the other, wherein each solar cell (10, 11, 12, 13) and each bypass diode (20, 21, 22, 23) comprises a photovoltaically active layer (32), a lower electrically conductive layer (31) and an upper electrically conductive layer (33) both of which adjoin the photovoltaically active layer (32), wherein solar cells (10, 11, 12, 13) electrically connected in parallel adjoin two opposite sides of each bypass diode (20, 21, 22, 23), and the solar cells (10, 11, 12, 13) adjacent to opposite sides of a bypass diode (20, 21, 22, 23) are electrically connected in parallel with the bypass diode (20, 21, 22, 23) therebetween, **characterized in that** a first bypass diode (20) is electrically separated from an adjoining second bypass diode (21) by two trenches (4) and an electrical conductor (2, 31) runs between the two trenches (4), which electrically conductively interconnects the upper electrically conductive layers (33) of the solar cells (10) of the plurality of solar cells (10, 11, 12, 13) which laterally adjoin the first bypass diode (20), and/or which electrically conductively interconnects the lower electrically conductive layers (31) of the solar cells (10) of the plurality of solar cells (10, 11, 12, 13) which laterally adjoin the second bypass diode (20).

2. Solar module according to one of the preceding claims, **characterized in that** the upper electrically conductive layer (33) of a first solar cell (10) is electrically conductively connected to the lower electrically conductive layer (31) of an adjoining second solar cell (11) by an electrical conductor (2).

3. Solar module according to the preceding claim, **characterized in that** the electrical conductor (2) spatially separates the photovoltaically active layer (32) of the first solar cell (10) from the photovoltaically active layer (32) of the second solar cell (10).

4. Solar module according to one of the preceding claims, **characterized in that** the lower electrically conductive layer (31) of a first solar cell (10) is electrically separated from the lower electrically conductive layer (31) of an adjoining second solar cell (11) by a first trench (1) and the upper electrically conductive layer (33) of the first solar cell (10) is electrically separated from the upper electrically conductive layer (33) of the adjoining second solar cell (11) by a second trench (3).

5. Solar module according to the preceding claim, **characterized in that** the first trench (1) is filled with the material of which the adjoining photovoltaically active layer (32) consists.

6. Solar module according to one of the two preceding claims, **characterized in that** the bottom of the second trench (3) is formed by a lower electrically conductive layer (31).

7. Solar module according to one of the preceding claims, **characterized in that** a lower electrically conductive layer (31) of a bypass diode (20, 21, 22, 23) is electrically separated from adjacent lower electrically conductive layers (31) of solar cells (10, 11, 12, 13) electrically connected in parallel by trenches (1a, 1b).

8. Solar module according to the preceding claim, **characterized in that** a trench (1a, 1b) electrically separating the lower electrically conductive layer (31) of the bypass diode (20, 21, 22, 23) from an adjacent electrically conductive layer (31) of a solar cell (10, 11, 12, 13) electrically connected in parallel is filled with the material of which the adjoining photovoltaically active layer (32) consists.

9. Solar module according to one of the preceding claims, **characterized in that** the upper electrically conductive layer (33) of a bypass diode (20, 21, 22, 23) is electrically separated from adjacent upper electrically conductive layers (33) of solar cells (10, 11, 12, 13) electrically connected in parallel by trenches (3a, 3b).

10. Solar module according to the preceding claim, **characterized in that** the bottom of a trench (3a, 3b) electrically separating the upper electrically conductive layer (33) of a bypass diode (20, 21, 22, 23) from an adjacent upper electrically conductive layer (33) of a solar cell (10, 11, 12, 13) electrically connected in parallel is formed by a lower electrically conductive layer (31).

11. Solar module according to one of the preceding claims, **characterized in that** the upper electrically conductive layer (33) of a bypass diode (20, 21, 22, 23) is electrically conductively connected to an adjacent lower electrically conductive layer (31) of a first solar cell (10, 11, 12, 13) electrically connected in parallel by means of an electrical conductor (2a), and the lower electrically conductive layer (33) of the bypass diode (20, 21, 22, 23) is electrically conductively connected to an adjacent upper electrically conductive layer (33) of a second solar cell (10, 11, 12, 13) electrically connected in parallel by means of an electrical conductor (2b).

12. Solar module according to the preceding claim, **characterized in that** an electrical conductor (2a, 2b) electrically connecting an electrically conductive layer (31, 33) of the bypass diode (20, 21, 22, 23) to an adjacent electrically conductive layer (33) of a solar cell (10, 11, 12, 13) electrically connected in parallel spatially separates the photovoltaically active layer (32) of the bypass diode (20, 21, 22, 23) from the photovoltaically active layer (32) of the solar cell (10).

13. Solar module according to one of the preceding claims, **characterized in that** the one or more trenches (4) separating a first bypass diode (20) from an adjoining second bypass diode (21) pass through all the layers (31, 32, 33) of the two bypass diodes (20, 21).

14. Solar module according to one of the preceding claims, **characterized in that** the solar cells (10, 11, 12, 13) and the bypass diodes (20, 21, 22, 23) are arranged in a plane.

15. Solar module according to one of the preceding claims, **characterized in that** the bypass diodes (20, 21, 22, 23) are shaded.

## Revendications

1. Module solaire avec une pluralité de cellules solaires (10, 11, 12, 13) disposées les unes derrière les autres et branchées électriquement en série, dans lequel une diode de dérivation (20, 21, 22, 23) est branchée électriquement en parallèle avec chaque cellule solaire (10, 11, 12, 13) pour le pontage électrique, dans lequel les diodes de dérivation (20, 21, 22, 23) sont disposées les unes derrière les autres, dans lequel chaque cellule solaire (10, 11, 12, 13) et chaque diode de dérivation (20, 21, 22, 23) comprennent une couche photovoltaïque active (32) ainsi qu'une couche inférieure électriquement conductrice (31) et une couche supérieure électriquement conductrice (33), lesquelles sont adjacentes à la couche photovoltaïque active (32), dans lequel à deux côtés opposés de chaque diode de dérivation (20, 21, 22, 23) des cellules solaires (10, 11, 12, 13) branchées électriquement en parallèle sont adjacentes, et les cellules solaires (10, 11, 12, 13) adjacentes aux côtés opposés d'une diode de dérivation (20, 21, 22, 23) sont reliées, de manière branchée électriquement en parallèle, avec la diode de dérivation (20, 21, 22, 23) située entre elles, **caractérisé en ce que** qu'une première diode de dérivation (20) est séparée électriquement d'une deuxième diode de dérivation (21) adjacente à celle-ci par deux tranchées (4) et qu'un conducteur électrique (2, 31) s'étend entre les deux tranchées (4) qui relie entre elles de manière électriquement conductrice des couches supérieures électriquement conductrices (33) de ces cellules solaires (10) qui sont adjacentes latéralement à la première diode de dérivation (20), et/ou qui relie entre elles de manière électriquement conductrice des couches inférieures électriquement conductrices (31) de ces cellules solaires (10) qui sont latéralement adjacentes à la deuxième diode de dérivation (20).

2. Module solaire selon l'une des revendications précédentes, **caractérisé en ce que** la couche supérieure électriquement conductrice (33) d'une première cellule solaire (10) est reliée de manière électriquement conductrice à la couche inférieure électriquement conductrice (31) d'une deuxième cellule solaire (11) adjacente par un conducteur électrique (2).

3. Module solaire selon la revendication précédente, **caractérisé en ce que** le conducteur électrique (2) sépare spatialement la couche photovoltaïque active (32) de la première cellule solaire (10) de la couche photovoltaïque active (32) de la deuxième cellule solaire (10).

4. Module solaire selon l'une des revendications précédentes, **caractérisé en ce que** la couche inférieure électriquement conductrice (31) d'une première cellule solaire (10) est séparée électriquement de la couche inférieure électriquement conductrice (31) d'une deuxième cellule solaire (11) adjacente par une première tranchée (1) et que la couche supérieure électriquement conductrice (33) de la première cellule solaire (10) est séparée électriquement de la couche supérieure électriquement conductrice (33) de la deuxième cellule solaire (11) adjacente par une deuxième tranchée (3).

5. Module solaire selon la revendication précédente, **caractérisé en ce que** la première tranchée (1) est remplie de ce matériau dont est constituée la couche photovoltaïque active (32) qui lui est adjacente.

6. Module solaire selon l'une des deux revendications précédentes, **caractérisé en ce que** le fond de la deuxième tranchée (3) est formé par une couche inférieure électriquement conductrice (31).

7. Module solaire selon l'une des revendications précédentes, **caractérisé en ce qu'**une couche inférieure électriquement conductrice (31) d'une diode de dérivation (20, 21, 22, 23) est séparée électriquement de couches inférieures électriquement conductrices (31) voisines de cellules solaires (10, 11, 12, 13) branchées électriquement en parallèle par des tranchées (1a, 1b).

8. Module solaire selon la revendication précédente, **caractérisé en ce qu'**une tranchée (1a, 1b) qui sépare électriquement la couche inférieure électriquement conductrice (31) de la diode de dérivation (20, 21, 22, 23) d'une couche électriquement conductrice (31) voisine d'une cellule solaire (10, 11, 12, 13) branchée électriquement en parallèle est remplie de ce matériau dont est constituée la couche photovoltaïque active (32) qui lui est adjacente.

9. Module solaire selon l'une des revendications précédentes, **caractérisé en ce que** la couche supérieure électriquement conductrice (33) d'une diode de dérivation (20, 21, 22, 23) est séparée électriquement des couches supérieures électriquement conductrices (33) voisines de cellules solaires (10, 11, 12, 13) branchées électriquement en parallèle par des tranchées (3a, 3b).

10. Module solaire selon la revendication précédente, **caractérisé en ce que** le fond d'une tranchée (3a, 3b) qui sépare électriquement la couche supérieure électriquement conductrice (33) d'une diode de dérivation (20, 21, 22, 23) d'une couche supérieure électriquement conductrice (33) voisine d'une cellule solaire (10, 11, 12, 13) branchée électriquement en parallèle, est formé par une couche inférieure électriquement conductrice (31).

11. Module solaire selon l'une des revendications précédentes, **caractérisé en ce que** la couche supérieure électriquement conductrice (33) d'une diode de dérivation (20, 21, 22, 23) est reliée à une couche inférieure électriquement conductrice (31) voisine d'une première cellule solaire (10, 11, 12, 13) branchée électriquement en parallèle est reliée de manière électriquement conductrice par un conducteur électrique (2a) et que la couche inférieure électriquement conductrice (33) de la diode de dérivation (20, 21, 22, 23) est reliée de manière électriquement conductrice par un conducteur électrique (2b) à une couche supérieure électriquement conductrice (33) voisine d'une deuxième cellule solaire (10, 11, 12, 13) branchée électriquement en parallèle.

12. Module solaire selon la revendication précédente, **caractérisé en ce qu'**un conducteur électrique (2a, 2b), qui relie électriquement une couche électriquement conductrice (31, 33) de la diode de dérivation (20, 21, 22, 23) à une couche électriquement conductrice (33) voisine d'une cellule solaire (10, 11, 12, 13) branchée électriquement en parallèle, sépare spatialement la couche photovoltaïque active (32) de la diode de dérivation (20, 21, 22, 23) de la couche photovoltaïque active (32) de la cellule solaire (10).

13. Module solaire selon l'une des revendications précédentes, **caractérisé en ce que** la une ou les plusieurs tranchées (4) qui séparent une première diode de dérivation (20) d'une deuxième diode de dérivation (21) adjacente à celle-ci traversent toutes les couches (31, 32, 33) des deux diodes de dérivation (20, 21).

14. Module solaire selon l'une des revendications précédentes, **caractérisé en ce que** les cellules solaires (10, 11, 12, 13) et les diodes de dérivation (20, 21, 22, 23) sont disposées dans un même plan.

15. Module solaire selon l'une des revendications précédentes, **caractérisé en ce que** les diodes de dérivation (20, 21, 22, 23) sont ombragées.
